# EUROPEAN PATENT APPLICATION

(11) **EP 4 177 372 A1**
(43) Date of publication of application: **10.05.2023**
(21) Application number: 21218421.2
(22) Date of filing: 30.12.2021
(51) Int. Cl.: C23C 16/27

(54) **A METHOD FOR GROWING BORON DOPED DIAMOND AND PRODUCT THEREOF**

(71) Applicant: Fyzikální ústav AV CR, v. v. i., 18221 Praha 8 (CZ); Slovenská Technická Univerzita v Bratislave, 812 43 Bratislava (SK)
(72) Inventor: Marton, Marian, 812 19 Bratislava (SK); Vojs, Marian, 812 19 Bratislava (SK); Michniak, Pavol, 812 43 Bratislava (SK); Behul, Miroslav, 812 43 Bratislava (SK); Rehacek, Vlastimil, 812 43 Bratislava (SK); Kromka, Alexander, 162 00 Praha 6 (CZ); Stehlik, Stepan, 162 00 Praha 6 (CZ)
(74) Representative: Bauer, Karel

(57) **Abstract**

The present invention relates to a method for growing a boron doped diamond using undiluted trimethylborate. The diamond structure is grown in chemical vapour deposition reactor at microwave power from 0,2 kW up to 100 kW at pressure less than 50 kPa. The method is capable to provide doped diamond with a wide range of doping levels. In a preferred embodiment, the present invention is capable to manufacture a boron-doped diamond layer employing linear antenna microwave chemical vapour deposition system without the need of addition of any other organic molecule, such as methane or methanol, to support the growth of the diamond structure. Electrical properties of such grown boron doped diamond can be controlled by adding additional source of oxygen.

## Description

### Technical field

The present invention relates to a method for fabrication a boron doped diamond structure. More particularly, the present invention pertains to a method for growing monocrystalline or polycrystalline boron doped diamond. Even more particularly, the invention pertains to a method of area larger than ≥ 45 cm² deposition of boron doped diamond via microwave plasma chemical vapour deposition from an organic liquid precursor comprising the dopant element in undiluted form.

In a second aspect, the present invention relates to a product thereof and use of the product as a coating for electrochemical sensing or as a supercapacitor or for hardening tool.

### Background of the Art

The well-known unique properties of boron-doped diamond make it an ideal candidate for many applications, where the electrochemical sensing and degradation using advanced oxidation processes are among the most common. Mainly the second mentioned requires large area boron-doped diamond films with low electrical resistivity. Moreover, several micrometres thick boron-doped diamond film is a must to avoid the failure of the electrochemical electrode due to a penetration of treated solution to the substrate causing substrate degradation and consequent boron-doped diamond delamination. Moreover, any of the industrial applications requires a cost-effective fabrication of boron-doped diamond electrodes. Hence, low-cost large area methods for producing several micrometres thick layers of highly boron doped diamond are of high interest.

In the state of the art, a polycrystalline diamond refers to freestanding bulk of diamond or diamond film (also referred as a thin layer) deposited on a substrate, composed of diamond crystals having different sizes in at least one dimension from 1 nm to 20 µm, wherein the diamond (sp³) is embedded in carbon (sp²) matrix. Hereinafter, we will use the term polycrystalline nanodiamonds for composed diamond crystals having size in at least one dimension from 1 nm to 500 nm. As a special embodiment of polycrystalline nanodiamonds, a state of the art literature refers to an ultrananocrystalline diamond as composed diamond crystals having size in at least one dimension from 1 nm to 20 nm. The term polycrystalline microdiamond refers to composed diamond crystals having size in at least one dimension from 500 nm to 20 µm.

While the large area hot filament chemical vapour deposition method is already available commercially, only two large area microwave plasma chemical vapour deposition techniques are known which have been explored up to day: the linear antenna and the distributed antenna array. The more intensively studied method is the linear antenna system, which was firstly mentioned in 2006 and later explored for the growth of intrinsic or boron doped diamond films.

Since the first published study, many successful attempts were already made to produce high quality boron-doped diamond films by large area microwave plasma chemical vapour deposition. A comprehensive study of gas precursor composition was published by A. Taylor, P. Ashcheulov, P. Hubík, L. Klimša, J. Kopeček, Z. Remeš, Z. Vlčková Živcová, M. Remzová, L. Kavan, E. Scheid, J. Lorinčík, V. Mortet, Precursor gas composition optimisation for large area boron doped nano-crystalline diamond growth by MW-LA-PECVD, Carbon. 128 (2018) 164-171. https://doi.org/10.1016/j.carbon.2017.11.063, who investigated the influence of gas mixture on the boron incorporation in the diamond film. Diborane (B₂H₆), the highly explosive and flammable gas, was used as the boron source. Authors claim that an addition of small amount of CO₂ is necessary for the growth of diamond layer, but at the same time, it negatively influences electrical conductivity (boron incorporation). Therefore, flow of the boron source precursor (diborane) corresponding to hundreds of thousands of ppm B/C ratio was necessary to achieve high boron doping levels, which is extremely high compared to the "conventional" rotational or multimode cavity (e.g. Aixtron P6 or ASTEX type) microwave chemical vapour deposition. Not only large area, but also a low temperature synthesis (below 300°C) is another advantageous characteristic of the large area microwave plasma chemical vapour deposition method. Unfortunately, growth rate becomes too low (<70 nm/hr) for highly boron-doped diamond films. Thus, requirements on hundreds of thousands of ppm B/C ratio and slow growth are cost ineffective as the growth of several micrometres thick diamond layers is needed, e.g. for the fabrication of large area boron-doped diamond electrodes for electrochemical applications.

To overcome the low growth rate drawbacks, alternative carbon sources including the solid or liquid ones have been investigated. These have some advantages over standardly used gaseous precursors, such as the much lower ordering costs, easier availability (e.g. graphite, acetone, methanol, ethanol), safety and handling and a wide range of composition elements. As progressive, chemical vapour deposition synthesis from liquid precursors seem to be promising for synthesis of intrinsic and boron doped diamond films. The growth rates were 10 to 100 times for acetone or so-called "In-liquid" chemical vapour deposition (methanol/ethanol) precursors, respectively. In the latter method, however, this is at the cost of reducing the homogeneity of the layer, which is a limiting factor for a number of applications.

Studies on using liquid precursors in the diamond chemical vapour deposition continued and one of the pioneering studies should be assigned to the work of Okano et al. who successfully doped diamond with boron by dissolving non-toxic trioxide (B₂O₃) powder in the methanol/acetone mixture during the hot filament CVD process K. Okano, H. Naruki, Y. Akiba, T. Kurosu, M. lida, Y. Hirose, Synthesis of Diamond Thin Films Having Semiconductive Properties, Jpn. J. Appl. Phys. 27 (1988) L173. https://doi.org/10.1143/JJAP.27.L173*.* This pioneering study attracted the attention of researchers, who have mixed the gas with liquid precursors to preserve heated filaments in oxygen-containing mixtures and to enhance the diamond growth rate. However, the inhomogeneous distribution of boron within the diamond layer forced researchers to use alternative precursors. Here, trimethylborate (B(OCH₃)₃) as the organoboron compound was shown as an effective source of boron from a liquid precursor in the microwave plasma chemical vapour deposition process C.-F. Chen, S.-H. Chen, T.-M. Hong, T.-C. Wang, Boron-doped diamond films using trimethylborate as a dopant source in methane-carbon dioxide gas mixtures, Diamond and Related Materials. 3 (1994) 632-637. https://doi.org/10.1016/0925-9635(94)90239-9*.* Since this work has been published, trimethylborate was adopted as the boron source in some works in which diamond films were primarily grown by the hot filament chemical vapour deposition processes. Up to now, trimethylborate was diluted to the maximum of 40 000 ppm B/C ratio whereas hydrocarbon (mostly methane) was used as the carbon source. As advantageous, high ppm B/C ratios (up to 333 000 ppm) can be simply achieved from trimethylborate in undiluted or slightly diluted form which solves exactly the above-mentioned technological obstacles related to large area microwave plasma chemical vapour deposition (i.e. the need for hundreds of thousands of B/C from expensive and highly explosive precursors: diborane/trimethylborane).

With respect to the drawbacks of the state-of-the-art, the present invention is solving the problem of incorporation of dopant into a diamond film or freestanding diamond, wherein the diamond film or the freestanding diamond is produced at relatively low pressure and temperatures.

### Summary of the Invention

The first aspect of the present invention is concerned with a method for growing a doped diamond as defined by claim 1.

The method according to the present invention comprises the steps:
- providing an undiluted trimethylborate; and
- setting pressure in a microwave plasma chemical vapour deposition (hereinafter MW CVD) reactor at up to 50 kPa, wherein the reactor comprises a substrate having temperature from 50 °C to 1300 °C; and
- initiating a chemical vapour deposition process by igniting plasma by microwave power from 0,2 kW up to 100 kW delivered by power supply working at frequency from 300 MHz to 30 GHz; and
- evaporating the undiluted trimethylborate and introducing the evaporation therefrom to the reactor; and
- introducing hydrogen into the reactor; wherein volume ratio between the evaporation and hydrogen is between 0.05% and 20%; and wherein
- the trimethylborate is the only liquid organic compound introducing the carbon and boron into the reactor, therefore serving as the boron and carbon precursor and supporting the growth of the boron doped diamond structure.

The method according to the present invention is providing monocrystalline or polycrystalline diamond having ultrananocrystalline or nanocrystalline or microcrystalline morphology, with high growth rate from 20 nm/hr up to 200 nm/hr, high doping level from 10¹⁷ up to 10²² cm⁻³ and low resistivity from 10⁻² ohm.cm up to 100 ohm.cm.

In some aspect, the method for growing a doped diamond is especially suitable for growing a doped diamond film or a thin layer on a substrate. In a preferred embodiment, the thickness of the diamond structure can be 20 µm or less with the above-mentioned quality. In more preferred embodiment, the thickness can be from 10 nm up to 20 µm, even more preferably from 500 nm up to 10 µm, even more preferably, from 1 µm up to 5 µm. The deposition can be provided by the state-of-the art method such as chemical vapour deposition.

In another embodiment, the diamond structure can be two diamond layers deposited on each respective surface of a substrate. In case of spatial body having more than two surfaces, the diamond layer can be provided on each respective surfaces of the body. In another embodiment, the diamond structure can be a multi-layered composite material having a periodic structure, such as a multilayer deposited on a substrate, wherein the first layer can be intrinsic diamond, the second layer can be a boron-doped diamond, the third layer can be intrinsic diamond and the fourth layer is another boron-doped diamond. The purity of the diamond or the dopant concentration in an artificially doped diamond, and order of the layers in the multilayer do not play a role as far as the final multilayer structure is compact.

In some embodiment, the diamond structure can be a freestanding diamond, such as a bulk of diamond material or a sheet of the artificially made diamond, i.e. diamond grown by the state of the art method, which are configured to have structural integrity without any support by a substrate.

Trimethylborate is the only organic composition, which is supporting the growth of the diamond structure and providing the boron dopant into the diamond structure. The dopant is comprised in the composition i.e. boron in trimethylborate. In accordance with the present invention, no further gaseous or liquid organic composition such as methane, methanol, etc. is needed. Trimethylborate is evaporated and is introduced into the reactor together with gas hydrogen. The concentration of trimethylborate in hydrogen is in the range 0.05 - 20% by volume.

In a preferred embodiment, the reduction of dopant/carbon ratio can be achieved utilizing a non-organic gaseous compound comprising oxygen such as water vapor, carbon dioxide, carbon monoxide, etc. The non-organic gaseous compound is evaporated, if needed, before its introduction into the reactor. The additional gaseous source of carbon and/or oxygen (e.g. CO₂, CO, O₂, H₂O vapour) can be used to control the B/C and B/O ratios in the deposition mixture of precursors to control the electrical properties of the boron doped diamond structure, more preferably films.

In a further preferred embodiment, the trimethylborate and hydrogen are introduced into the reactor separately. The introduction of separate gasses provides an advantage to measure volume of each gas, provided a flow meter is attached to the source of the respective gas.

Oxygen released from the trimethylborate molecule is high enough to support the microcrystalline diamond growth, which is in contrast to state-of-the art, where adding CO₂ was needed to facilitate the growth at temperature below 600 °C leading to sp³ diamond phase higher than 90% and crystal size larger than 100 nm, wherein the diamond is boron-doped.

In a preferred embodiment, the gases introduced into the reactor consist of trimethylborate, hydrogen and CO₂. More preferably, trimethylborate flow is in range from from about 0,2 % to about 2 % by volume. Even more preferably CO₂ flow is from about 1 % to about 2 % by volume. The both configuration can advantageously manufactured an ultrananocrystaline and nanocrystaline diamond having boron dopant and concentration of charge carrier and resistivity as mentioned above as growth rate from about 50 nm/h up to 170 nm/h.

In a more preferred embodiment, the gases introduced into the reactor consist of trimethylborate and hydrogen. In this embodiment, only two gasses are introduced in the reactor. This embodiment provides sufficient condition for growth of the doped diamond structure while preserving resources.

In a further preferred embodiment, the MW CVD reactor is linear antenna microwave chemical vapour deposition reactor, which is set to the delivery of continuous or pulsed electrical power at microwave frequencies typically in the range 300 MHz to 30 GHz. The pressure in the reactor according to the present invention is set up to 50 kPa. The microwave linear antenna CVD reactor is set to 0,2 kW - 100 kW. The content of carbon, oxygen and boron in trimethylborate alone is sufficient to activate the growth of boron doped diamond film. The higher demand for dopant in this type of reactor allows the use of undiluted trimethylborate without a degradation of the diamond structure compared to the known degradation from the focused plasma reactors with boron to carbon ratio exceeding 14 000 ppm (E. Gheeraert, A. Deneuville. J. Mambou, Caebon 37 (1) (1999) 107-111. https://doi.org/10.1016/S0008-6223(98)00192-4). In a more preferred embodiment, the MW CVD reactor is set to microwave power about 6 KW and the pressure about 30 Pa and setting the substrate temperature about 600 °C. This embodiment advantageously provides high growth rate. In another advantageous embodiment, MW CVD reactor is set to the microwave power from about 1200 W to about 1700 W.

In another embodiment, the method comprises the step of setting the linear antenna microwave chemical vapour deposition reactor substrate holder to direct current controlled by the bias power supply. Connected direct current accelerates the growth corresponding species towards the substrate leading to increased formation of diamond nuclei and enables high density of diamond nucleation. The step also allows the control of size of forming diamond crystals compared to the method of growth mentioned in (M. Vojs, M. Veselý, R. Redhammer, J. Janík, M. Kadlečíková, T. Daniša, M. Marton, M. Michalka, P. Šutta: Double bias HF CVD multilayer diamond films on WC-Co cutting tools, Diamond and Related Materials 14 (3-7), (2005) 613-616. https://doi.org/10.1016/j.diamond.2005.01.006).

In another embodiment, the method further comprising setting the linear antenna microwave chemical vapour deposition reactor substrate holder to alternating or pulsating current controlled by the bias power supply. Connected alternating or pulsating current accelerates the growth corresponding species towards the substrate leading to increased formation of diamond nuclei and enables high density of diamond nucleation compared to the method mentioned in A. Kromka, J. Janík, F. Balon, M. Kubovič, I. Červeň, V. Dubravcová: Comparison of diamond nucleation in DC and AC substrate bias mode, Thin Solid Films 433 (1-2) (2003) 73-77. http://dx.doi.org/10.1016/S0040-6090(03)00288-8.

In a second aspect of the present invention, a boron doped diamond as defined in claim 12 is provided.

The boron doped diamond comprising:

boron respective charge carriers, wherein the concentration thereof is varied from 10¹⁷ to 10²² cm⁻³ ; the resistivity of the diamond is less than 10² ohm.cm.

In a preferred embodiment, the diamond is polycrystalline diamond.

In another preferred embodiment, the size of the diamond crystals is less than 20 nm.

In another preferred embodiment, the diamond is a layer deposited on a substrate.

In another embodiment, use of the boron doped diamond is provided. The diamond has charge carriers concentration more than 3·10²⁰ cm⁻³ for electrochemical electrodes for sensing and/or degradation of micropollutants; hydrogen evolution; supercapacitors; photoelectrochemical cells.

In another embodiment, use of the boron doped diamond according anyone of the previous embodiment is provided as a coating for a cutting tool.

### Brief description of the drawings

Fig.1 represents schematic drawing of the large area linear antenna microwave chemical vapour deposition reactor.
Fig. 2a - 2d. shows calculated a) H/C, b) O/C, c) B/O, and d) B/C ratios as a function of used TMBT and CO₂ gas flows.
Fig.3. represents SEM images of boron-doped diamond (scale bars represent 100 nm).
Fig. 4a -4b represent a graph of growth rates of the boron-doped diamond in dependence on gas flows
Fig. 5 represents Arrhenius plot and calculated activation energies of diamond film deposited at different substrate temperatures and 1% TMBT and 0.2% CO₂ in H₂.
Fig. 6a - 6e represent graphs of Raman spectra acquired using 633 laser, TMBT concentration: a) 0.2%, b) 0.5%, c) 1%, d) 2%, e) 4%, CO₂ concentration: (1) 0, (2) 1 sccm, (3) 2 sccm, (4) 4 sccm, (5) 8 sccm, (6) 16 sccm.
Fig. 7a and 7b represent graphs of electrical properties: charge carriers concentration (p) and resistivity (r) in dependence on trimethylborate and CO₂ flow as recorded by Hall measurement.
Fig. 8a - 8e represent schematic drawings of applications of the BDD film.

### Detailed description of the embodiments

### Diamond growth

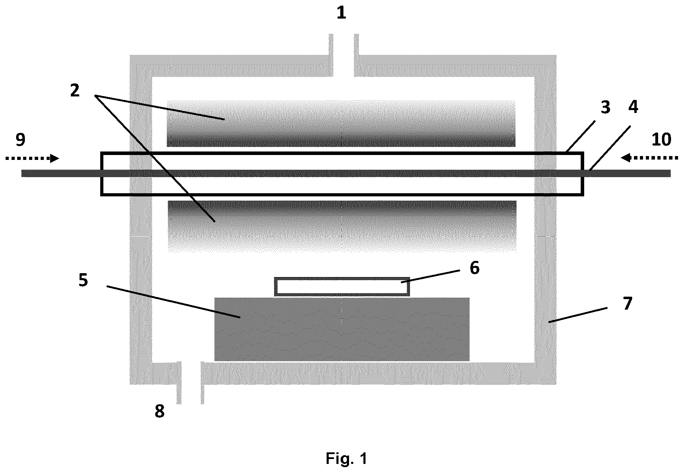

Boron doped diamond films were grown on polished Si (100) and quartz glass substrates cut to 1×1 cm², cleaned in acetone, isopropanol and deionized water and ultrasonically seeded with diamond nanoparticles having size of 5 nm in deionized water suspension. Depositions were performed for 15 hours in the linear antenna microwave chemical vapour deposition reactor (**Fig.1**) using 6 kW of microwave power (2 × 3 kW with the 8 ms On / 6 ms Off timing and 50% phase shift for each of the two antennas), at 590°C substrate temperature and 30 Pa pressure. **Fig. 1** schematically shows a microwave CVD reactor for synthesis of diamond with microwave activation. The reactor comprises a plasma reactor chamber connected to a source of feed gases, which are at least trimethylborate and hydrogen. In some example, there can be an addition source of CO or CO2 or any of the above-mentioned gasses. The gases are introduced via an inlet 1 into the CVD reactor chamber. **Fig. 1** schematically shows only one inlet, however, the chamber can comprise plurality of inlets for each respective gases and preferably provided with a flow meter for measurement of introduces volume of respective gasses. The reactor chamber further comprises a source of microwave power. Plasma **2** is created within the chamber by microwave generator. The chamber of the CVD reactor is designed to form a resonator supporting the field of standing microwave waves. The microwave generator operates at a frequency in the range 300 MHz to 30 GHz. CVD reactor is further provided with a quartz tube **3** as a furnace tube. The quartz tube **3** is used as a dielectric material which covers a linear antenna **4**. The linear antenna **4** made of metal is placed at the centre of the quartz tube **3**, followed by evacuation up to 50 kPa or less. After heating while allowing hydrogen gas to flow, trimethylborate is added while the temperature of a substrate **6** mounted on a substrate holder **5** is set to 50 °C - 1300 °C, MW CVD treatment of the substrate **6** is performed. The substrate 6, quartz tube **3** and linear antenna **4** are mounted in a vacuum chamber **7.** The vacuum chamber **7** is vacuated by a vacuum pump **8** for setting the pressure bellow 50 kPa. The linear antenna **4** is connected to a microwave power from a first source **9** and from a second source **10.**

Trimethylborate (Sigma-Aldrich, purum, ≥99.0% (GC)) was evaporated and introduced into the vacuum chamber **7** through a gas flow meter set to 1, 2.5, 5, 10 or 20 sccm (0.2%, 0.5%, 1%, 2% or 4%, respectively). The effect of carbon dioxide was investigated by adding 0, 1, 2, 4, 8 and 16 sccm (0, 0.2%, 0.4%, 0.8%, 1.6% and 3.2%, respectively) into the gas mixture. The hydrogen flow was set to 500 sccm for all experiments and was constant for the whole experiment.

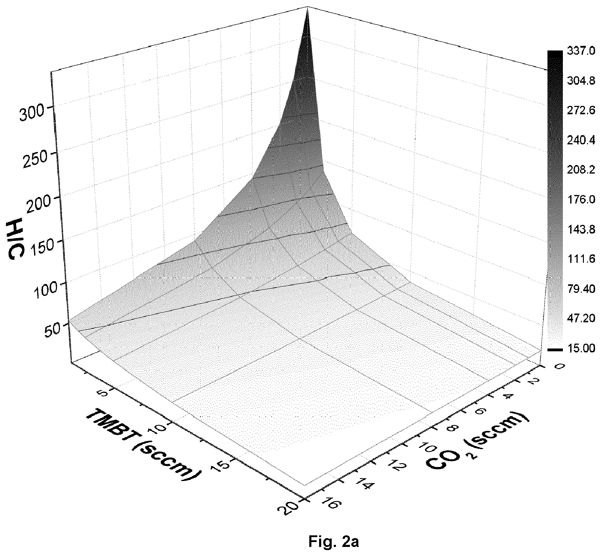

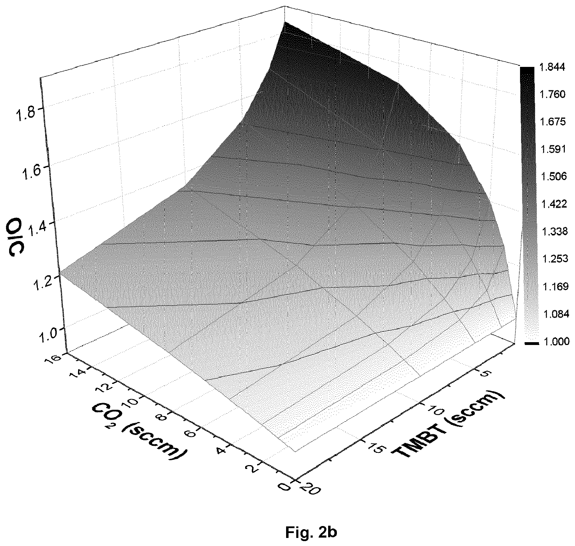

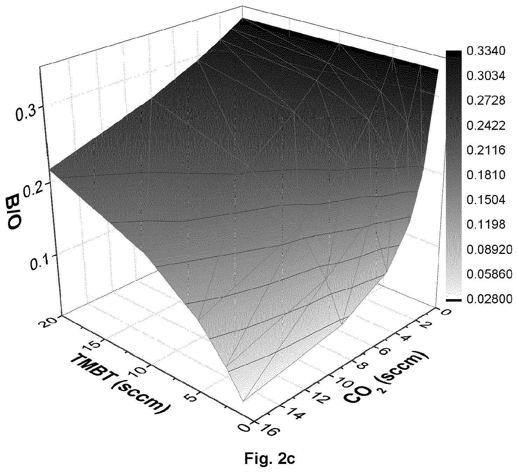

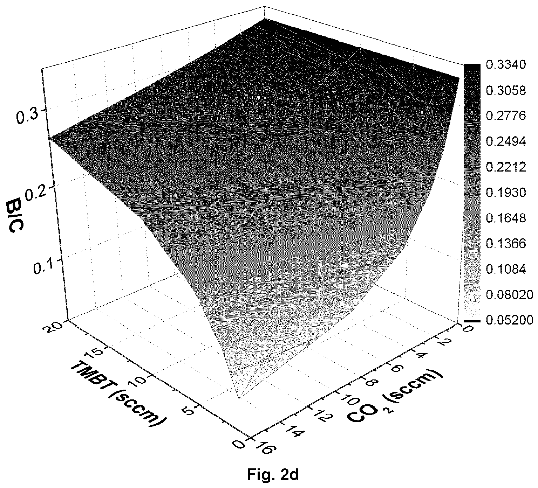

**Figures 2a- 2d** depict the calculated hydrogen-to-carbon, oxygen-to-carbon, boron-to-oxygen, and boron-to-carbon ratios depending on the amount of introduced trimethylborate and CO₂ gases used in inventor's experiment. In particular, **Fig. 2a-2d** show H/C, O/C, B/O, and B/C ratios as a function of used TMBT and CO₂ gas flows. Depending on the gas flow meters setting, the provided B/C ratio in the gas mixture in the reactor chamber during deposition was in the range from 52 000 ppm to 333 000 ppm in individual experiments.

### Analyses and characterization

The boron doped diamond films grown by the described method were investigated employing electron microscopy. JEOL 7500f (45° angle view) microscope was used to investigate the surface morphology and boron-doped diamond film thickness (cross-section views). Chemical composition of deposited films was evaluated from Raman spectra which were acquired by 633 nm (Dilor system, 5 µm spot diameter). Hall measurements (4-points Van der Pauw method) done at room temperature were applied for determination of electrical properties (resistivity, carrier concentration) of samples prepared on quartz glass and contacted through vacuum evaporation of 10 nm Cr and 100 nm Au multilayer pads. The results of investigation are described below.

### Morphology and structure

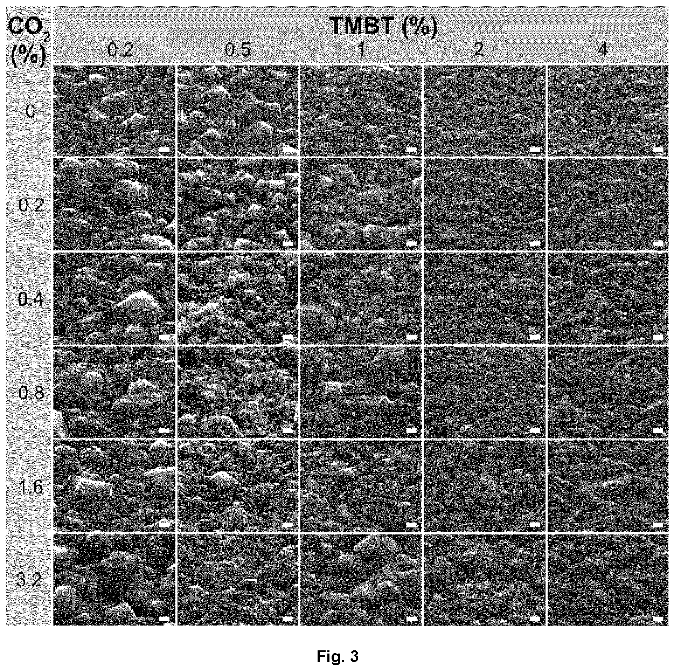

First, we investigated the influence of gas composition on the diamond film morphology using scanning electron microscopy. In general, considering the grain size, diamond films can be divided to ultrananocrystalline diamond having size <20 nm, nanocrystalline diamond having size 20 ÷ 500 nm and micro crystalline diamond having size >500 nm of crystalline. Scanning electron microscope images reveal polycrystalline diamond films with crystal sizes from micro- through nano- to ultranano-crystalline dimensions depending on both trimethylborate and CO₂ flows shown in **Fig.3****.** Hence, the method used is capable to grow doped diamond films with defined crystal size and corresponding properties such as surface/volume carbon hybridisation heterogeneity, sp³/sp² carbon ratio and surface roughness (given by the size of the crystals).

When trimethylborate is used as the only source of C, B and O in the gas mixture, the film morphology is summarized in the first line in **Figure 3****.** A typical polycrystalline diamond film was grown with crystal sizes decreasing from hundreds of nanometres to nanometres depending on the flow of trimethylborate varied in the range from 0,2% (1 sccm) to 4% (20 sccm) in hydrogen. The trimethylborate molecule contains of three times more carbon atoms (compared to CO₂) which sharply changes the C/H ratio (**Fig.2a**) and its variations influence the film morphology as follows: increasing of the trimethylborate content with respect to background hydrogen results in decreasing the crystal size down to ultrananocrystalline range for the highest trimethylborate flow (20 sccm (4%) of trimethylborate in 500 sccm of hydrogen). The observation confirmed that just with trimethylborate as the only source of C, B, O in gas mixture, the method is capable to grow doped diamond films with controllable crystal size and corresponding properties such as surface/volume carbon hybridisation heterogeneity, sp³/sp² carbon ratio and surface roughness (given by the size of the crystals). The ultrananocrystaline diamond like morphology is similar to morphologies found for films grown at high CH₄ in the "conventional" rotational or multimod cavity microwave chemical vapour deposition reactor (e.g. Aixtron P6 or ASTEX type) or in argon-rich gas mixtures (iplas type system, etc.).

The inventors further investigated the influence of adding CO₂ to the trimethylborate /H₂ gas mixture to controllably set up B/C and B/O ratio and so, to control final electrical properties of grown diamond from chemical vapour deposition. Increasing the content of CO₂ in the gas mixture shows two common effects on the film morphology (**Fig. 3**) and reflects the total amount of carbon already added by trimethylborate. For low trimethylborate concentrations in the gas mixture (1 and 2.5 sccm, i.e. 0.2 and 0.5 %)), adding CO₂ more steeply increases the relative amount of both carbon and oxygen which causes mainly decreasing of crystal size and disordering. When the trimethylborate concentrations (by volume) are high enough (e.g. 5 sccm flow (1% in H₂), 10 sccm flow (2% in H₂) and 20 sccm flow (4% in H₂)), there already is a high amount of carbon in the gas mixture, CO₂ positively acts like a source of an etchant (oxygen) which further enhances etching of non-diamond phases. As the final effect, diamond crystals reveal a slight increase of size shifting the growth regime from ultranano- to nano- (for 10 sccm (2% in H₂) and 20 sccm (4% in H₂) of trimethylborate) and micro-crystalline (for 5 sccm (1% in H₂) of trimethylborate) growth. Using electron microscopy for investigation of the morphology in dependence on the CO₂ flow has shown that adding CO₂ to the gas mixture gives a further tool to control the morphology related properties such as surface/volume carbon hybridisation heterogeneity, sp³/sp² carbon ratio and surface roughness (given by the size of diamond crystals).

### Growth kinetics

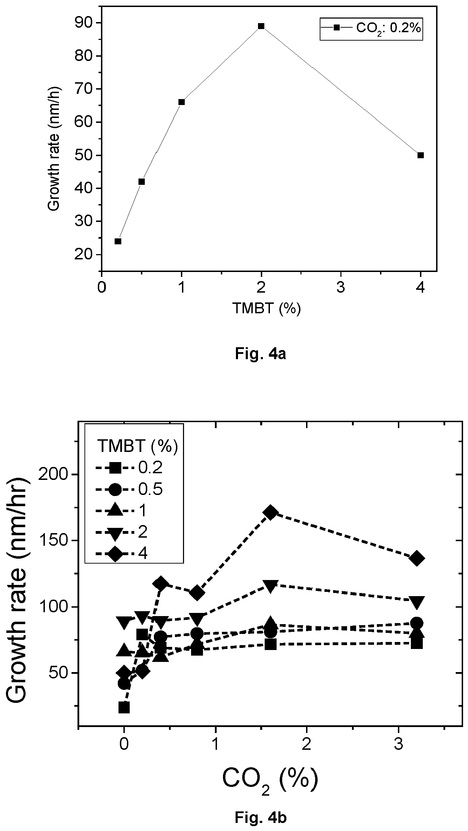

Inventors further investigated the growth rate of doped diamond grown by the described method. **Figures 4a and 4b** plot growth rates as a function of trimethylborate and CO₂ content. The growth rate without added CO₂ (**Fig.4a**) monotonically increases from 24 to 90 nm/h with increasing trimethylborate content in H₂ from 1 sccm (0.2%) to 10 sccm (4%), respectively. For the highest trimethylborate content (4%, i.e. 20 sccm), the growth rate dropped down to 50 nm/h. Addition of CO₂ (**Fig.4b**) enhanced the growth rate almost in all cases. For the highest trimethylborate content (4%, i.e. 20 sccm), the growth rate reached maximum (170 nm/h) for CO₂ at 8 sccm (1.6%). This value is nearly three times higher than the value (50 nm/h) found for the film grown without CO₂. For the highest CO₂ (3.2%, i.e. 16 sccm), the growth rate decreases to 137 nm/h. Increased growth rates are crucial for cost effective large-area growth of boron doped diamond films with high doping level and low resistivity used in electrochemistry as electrodes for sensing, degradation, and supercapacitors and for coating cutting tools.

The achieved growth rates of boron-doped diamond using trimethylborate in linear antenna microwave plasma reactor (operated at 6 kW power, 30 Pa chamber pressure, 590 °C substrate temperature) are up to 2 times higher than the values reported in a low pressure chemical vapour deposition system (40 nm/hr for boron doped diamond film with resistivity 0.02 ohm.cm and 60 nm/hr for boron doped diamond film with resistivity 0.03 ohm.cm) published by A. Taylor, P. Ashcheulov, P. Hubík, L. Klimša, J. Kopeček, Z. Remeš, Z. Vlčková Živcová, M. Remzová, L. Kavan, E. Scheid, J. Lorinčík, V. Mortet, Precursor gas composition optimisation for large area boron doped nano-crystalline diamond growth by MW-LA-PECVD, Carbon. 128 (2018) 164-171. https://doi.org/10.1016/j.carbon.2017.11.063, in comparison with growth rates (50 nm/hr to 90 nm/hr) for boron doped diamond films with comparable or lower resistivity (0.01 - 0.03 ohm.cm) and up to 3 times in comparison with growth rates for heavily doped diamond films (170 nm/hr, 0.05 ohm.cm) grown by the described method using the liquid trimethylborate.

### Activation energy - Arrhenius plot

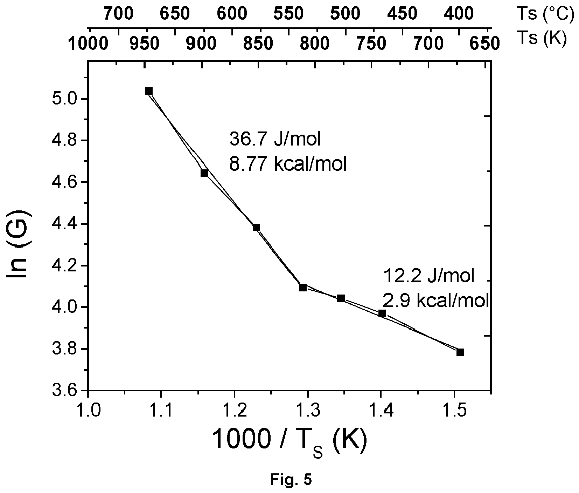

The growth kinetics of the boron doped diamond films grown by the described method at low pressure was further characterized by activation energy (Eₐ) which was calculated from the Arrhenius plot. (**Fig. 5**) shows the dependence of natural logarithm of the growth rate vs. reciprocal value of T_{S} (known as a substrate temperature). The plotted line reveals two slopes with "milder" increase for temperatures up to 550°C and the second characterized by steeper slope for temperatures higher than up to 550°C. The calculated activation energies are 2,9 and 8,77 kcal/mol for a low (<550 °C) and high temperature region (>550 °C). These Eₐ values are much lower than values for films grown at higher pressures (>2 kPa) in hydrogen rich plasma (22-30 kcal/mol). The calculated Eₐ lower than 4 kcal/mol enables growth of boron-doped diamond at very low temperatures (below 250°C and lower) and allows the use of low temperature substrates (polymers, composites, glass, metals, etc.) for growth of boron doped diamond films by the described method. This result supports further lowering of costs for fabrication of doped diamond films.

In our growth process, we used a gas mixture of trimethylborate in hydrogen without any need of methane, or other organic source of carbon, for diamond growth. Moreover, a certain amount of oxygen coming from the trimethylborate molecule was enough high to support the microcrystalline diamond growth which is in contrast to previous finding, where adding CO₂ was needed to change the growth kinetic from growing SiC to nano- and micro-crystalline diamond film character.

### Chemical composition

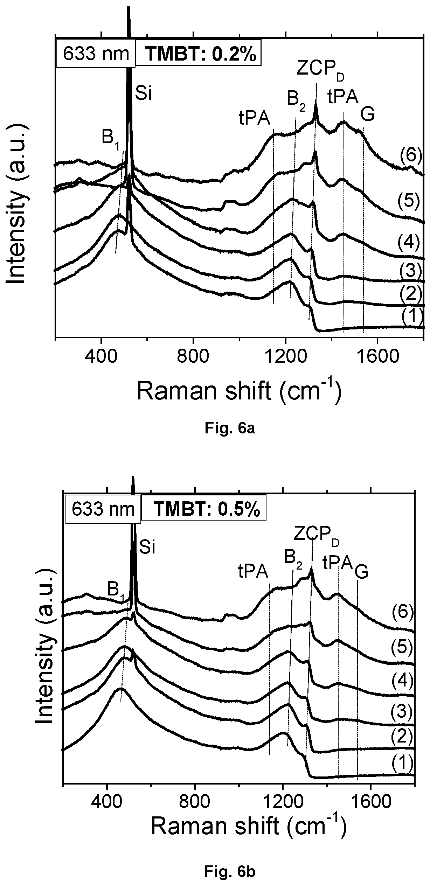

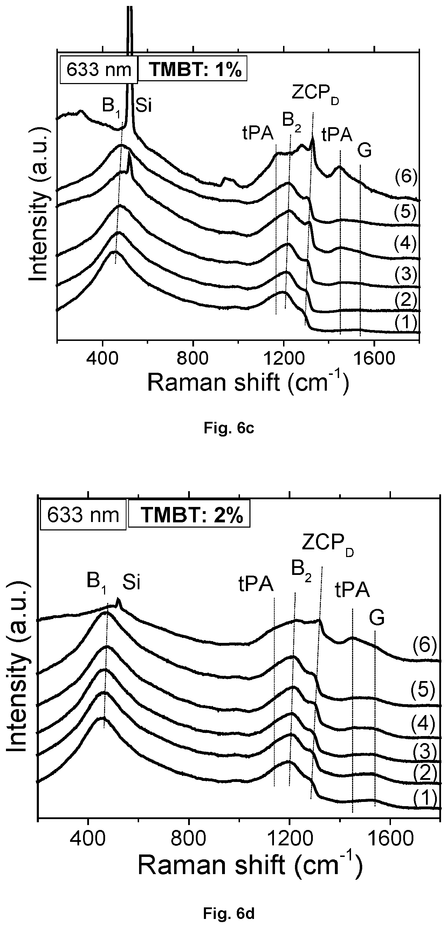

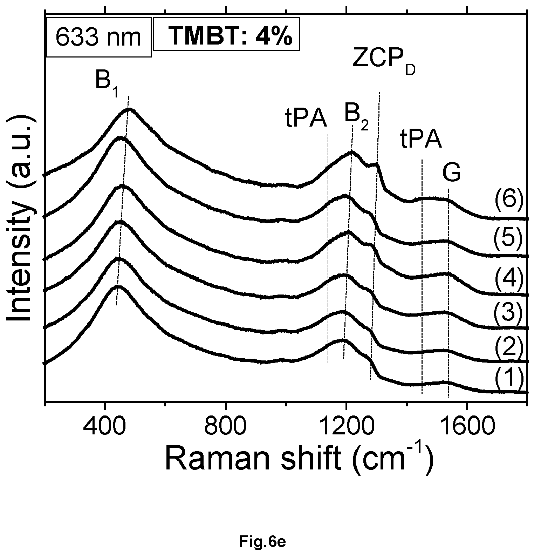

Considering the recorded Raman spectra as shown in Fig. 6a - 6e, adding of CO₂ decreased incorporation of boron and appropriate change of Raman maxima is best visible in the case of low trimethylborate content (flow), where also the change in both B/C and B/O ratios is most significant and the boron atoms concentration in gas mixture is relatively low and allows wider process windows to be compensated by oxygen.

Hence, the spectra change from the typical "NCD" shaped, with the transpolyacetylene maxima at 1150 and 1450 cm⁻¹, zone center phonon mode of diamond at about 1333 cm⁻¹ and the graphitic band at about 1560 cm⁻¹, to the typical "Fano" shaped highly boron doped diamond spectra with bands at about 500 cm⁻¹ and 1200 cm⁻¹, both connected with incorporated boron, and shifted zone center phonon mode maximum. The influence of CO₂ on the Raman spectra features connected with boron doping is less and less visible with the increasing trimethylborate flow, because the change in B/C and B/O ratios is smaller. In the case of the highest trimethylborate flow, the further adding of CO₂ decreases the B/C ratio only slightly and is thus not able to significantly affect the spectra showing a strong boron doping. The added oxygen is not able to compensate the high boron content considerably as well. Raman spectra of boron doped diamond films grown by the described method confirmed the possibility to control the doping level and related electrical properties by controlling the B/C and B/O ratios in gas phase employing CO₂.

### Electrical properties

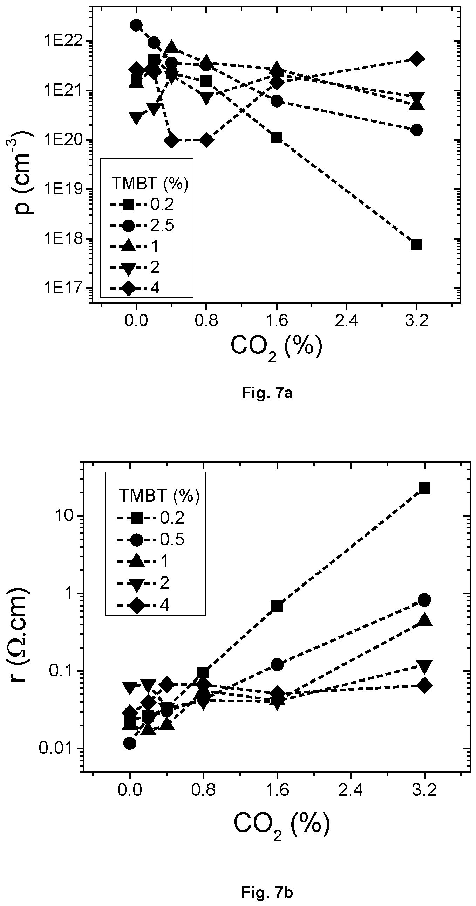

Investigation of doped diamond films grown by the described method employing Hall measurement revealed very high values of charge carriers concentration exceeding 10²¹ cm⁻³ for almost all used trimethylborate and CO₂ concentrations (**Fig.7a - 7b**). The highest concentration (p = 2×10²² cm⁻³) together with the lowest resistivity (1.16×10⁻² Ω.cm) were found in the case of 0.5% (2.5 sccm) trimethylborate flow and no added CO₂. The recorded values of (p) were less or more affected by the added CO₂. As we have expected, the largest change in B/C and B/O ratios after adding CO₂ in the case of boron-doped diamond layers grown with low trimethylborate flow (0.2 and 0.5%, i.e. 1 and 2.5 sccm) led also to the most significant change in the doping level and resistivity. In the case of the middle trimethylborate flow (5 and 10 sccm) this trend is not so much visible. At the beginning, it is even reverse, most possibly due to the competition of improvement of the diamond crystal quality leading to improvement of electrical properties, and the effect of decreasing of B/C and B/O ratios. For the highest trimethylborate flow, after an initial decrease of doping level after adding CO₂, it continually grows to reach the highest recorded value. Similarly, after an initial increase, resistivity in this case decreases slightly and by continual improvement of layer quality (enlarging grains) resists the compensation effects of oxygen, visible for lower trimethylborate flows. Hall measurement characterisations of boron doped diamond films grown by the described method confirmed the possibility to control the doping level and related electrical properties by controlling the B/C and B/O ratios in gas phase employing CO₂. The wide range of achieved doping level and resistivity values enables the use of boron doped diamond films grown by the described method in applications requiring metal like conductivity with charge carriers concentration exceeding 3*10²⁰ cm⁻³ (electrochemical electrodes for sensing and degradation of micropollutants and hydrogen evolution, supercapacitors, micro/nano electromechanical devices, photoelectrochemical cells).

The main application potential of the product of doped diamond films is in the field of electrochemistry as electrodes. In general, the product has the advantage of very high boron doping level of up to 10²² cm⁻³, low electrical resistivity 10⁻² ohm.cm, chemical inertness, controllable crystal size and the possibility of fabrication in a large area microwave chemical vapour deposition system.

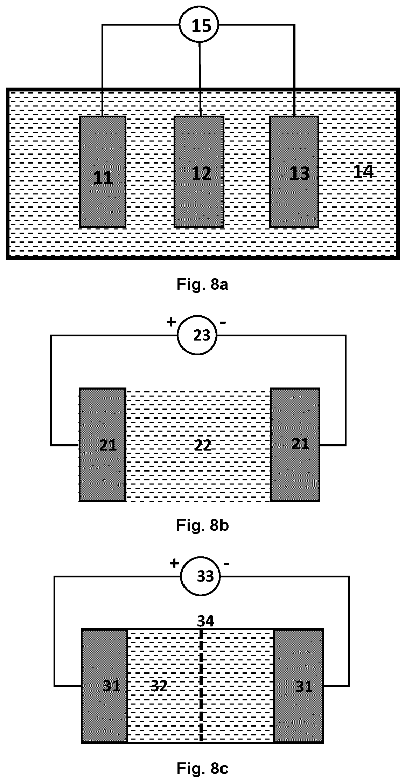

The electrochemical sensor **(****Fig.8a****)** based on the doped diamond produced by the described method has the advantage of very high doping level of up to 10²² cm⁻³ and corresponding concentration of electrochemically active surface sites. Furthermore, it possesses low electrical resistivity 10⁻² ohm.cm, chemical stability, low fouling, wide electrochemical potential window (3 - 4 V) and quasi reversible electron transfer. **Fig. 8a** represents an electrode electrochemical sensing system with the BDD film used as the electrode material. **Fig. 8a** in particular shows a BDD working electrode **11**, a counter electrode **12**, a reference electrode **13**, a solution with analyte **14** and a potentiostat **15**.

The doped diamond electrode employed for electrochemical degradation using advanced oxidation processes **(****Fig.8b****)** produced by the described method has the advantage of very high doping level of up to 10²² cm⁻³, corresponding concentration of electrochemically active surface sites and low electrical resistivity (10⁻² ohm.cm), chemical stability, resistance to corrosion and wide electrochemical potential window (3 - 4 V) leading to improved energy efficiency and effectivity of degradation of compounds when compared to diamond films with doping level below 10²¹ cm⁻³. **Fig. 8b** in particular shows an electrochemical cell for degradation using advanced oxidation processes with the doped diamond film used as the electrode material, especially a doped diamond electrodes **21**, a compound for degradation **22**, and a power source **23**.

The doped diamond films as electrodes for supercapacitors **(****Fig.8c****)** can be produced by the described method with controlled crystal size in the range from ultrananocrystalline to microcrystalline. This feature allows to tune the process of making porous diamond structure by thermal etching using catalysts, allowing to tune the surface area and specific capacity. **Fig. 8c** shows supercapacitor with the doped diamond film used as the electrode material, in particular a doped diamond electrodes **31,** an electrolyte **32,** a power source **33,** and a separator **34.**

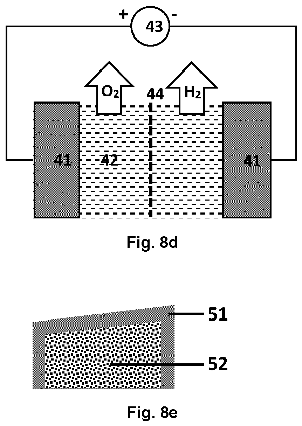

Hydrogen evolution cell with doped diamond electrochemical electrodes produced by the described method **(****Fig.8d****)** benefit from the high doping level (up to 10²² cm⁻³), low resistivity (10⁻² ohm.cm), chemical inertness and corrosion resistance of diamond, controllable crystal size and corresponding tuneable surface sp³/sp² ratio allowing to shift the hydrogen evolution potential to more positive potentials, and such decreasing the energy consumption. **Fig. 8d** shows hydrogen evolution cell with the BDD film used as the electrode material, in particular a doped diamond electrodes **41,** an electrolyte **42,** a power source **43,** and a separator **44.**

In the case of application as hard coating for cutting tools **(****Fig.8e****),** the possibility to grow diamond with low surface roughness (resulting from crystal size about 10 nm) is an advantage due to the lowered sticking of machined material on the tool, improved durability of the tool and precision of machining. **Fig. 8e** in particular shows doped diamond film used as a hard coating for cutting tool, especially a doped diamond film **51,** and a cutting tool **52.**

## Claims

1. A method for growing boron doped diamond comprising steps:
- providing an undiluted trimethylborate;
- setting pressure in a microwave plasma chemical vapour deposition reactor at up to 50 kPa, wherein the reactor comprises a substrate having temperature from 50 °C to 1300 °C; and
- initiating a chemical vapour deposition process by igniting plasma by microwave power from 0,2 kW up to 100 kW delivered by power supply working at frequency from 300 MHz to 30 GHz; and
- evaporating the undiluted trimethylborate and introducing the evaporation therefrom to the reactor; and
- introducing hydrogen to the reactor; wherein volume ratio between the evaporation and hydrogen is between 0.05 - 20%; and **characterized in that**
- the trimethylborate evaporation is the only organic compound introducing the carbon and dopant into the reactor, supporting the growth of the doped diamond structure.

2. The method according to claims 1 further comprising introducing gaseous compound comprising oxygen, preferably gaseous H₂O and/or O₂ and/or CO and/or CO₂, into the reactor.

3. The method according to anyone of the preceding claims, wherein the step of introducing the gasses to the reactor is introducing the gasses into a linear antenna microwave chemical vapour deposition reactor.

4. The method according anyone of the preceding claims, wherein introducing gasses into the reactor consist of trimethylborate, hydrogen and CO₂.

5. The method according to anyone of the preceding claims, wherein the gases are introducing into the reactor separately via a flow meter.

6. The method according to anyone of the claims 3 - 5 further comprising setting the linear antenna microwave chemical vapour deposition reactor substrate holder to direct current.

7. The method according to anyone of the claims 3 - 5 further comprising setting the linear antenna microwave chemical vapour deposition reactor substrate holder to alternating current.

8. The method according to anyone of the preceding claims, wherein the step of introducing trimethylborate into the reactor is from about 1 % to about 2 % by volume.

9. The method according to anyone of the preceding claims, wherein the step of introducing CO₂ into the reactor is from about 0.2 % to about 2 % by volume.

10. The method according to anyone of the preceding claims, wherein comprising the step of setting microwave power about 6 KW and the pressure about 30 Pa and setting the substrate temperature about 600 °C.

11. The method according to anyone of the claims 1 - 9 comprising the step of setting the microwave power of the reactor from about 200 W to about 6000 W.

## Amended claims

### Amended claims in accordance with Rule 137(2) EPC.

**1.** A method for growing boron doped diamond comprising steps:
- providing an undiluted trimethylborate;
- setting pressure in a microwave plasma chemical vapour deposition reactor at up to 50 kPa, wherein the reactor comprises a substrate having temperature from 50 °C to 1300 °C; and
- initiating a chemical vapour deposition process by igniting plasma by microwave power from 0,2 kW up to 100 kW delivered by power supply working at frequency from 300 MHz to 30 GHz; and
- evaporating the undiluted trimethylborate and introducing the evaporation therefrom to the reactor; and
- introducing hydrogen to the reactor; wherein volume ratio between the evaporation and hydrogen is between 1 - 20%; and **characterized in that**
- the trimethylborate evaporation is the only organic compound introducing the carbon and boron into the reactor, supporting the growth of the doped diamond structure; and wherein volume concentration of trimethylborate is at least 5 sccm; and wherein the method further comprises the step of
- introducing CO₂ into the reactor.

**2.** The method according to claim 1, wherein the step of introducing the gasses to the reactor is introducing the gasses into a linear antenna microwave chemical vapour deposition reactor.

**3.** The method according anyone of the preceding claims, wherein introducing gasses into the reactor consist of trimethylborate, hydrogen and CO₂.

**4.** The method according to anyone of the preceding claims, wherein the gases are introducing into the reactor separately via a flow meter.

**5.** The method according to anyone of the claims 2 - 4 further comprising setting the linear antenna microwave chemical vapour deposition reactor substrate holder to alternating current.

**6.** The method according to anyone of the claims 2 - 4 further comprising setting the linear antenna microwave chemical vapour deposition reactor substrate holder to alternating current.

**7.** The method according to anyone of the preceding claims, wherein the step of introducing trimethylborate into the reactor is from about 1 % to about 2 % by volume.

**8.** The method according to anyone of the preceding claims, wherein the step of introducing CO₂ into the reactor is from about 0.2 % to about 2 % by volume.

**9.** The method according to anyone of the preceding claims, wherein comprising the step of setting microwave power about 6 KW and the pressure about 30 Pa and setting the substrate temperature about 600 °C.

**10.** The method according to anyone of the preceding claims comprising the step of setting the microwave power of the reactor from about 200 W to about 6000 W.

**1.** A method for growing boron doped diamond comprising steps:
- providing an undiluted trimethylborate;
- setting pressure in a microwave plasma chemical vapour deposition reactor at up to 50 kPa, wherein the reactor comprises a substrate having temperature from 50 °C to 1300 °C; and
- initiating a chemical vapour deposition process by igniting plasma by microwave power from 0,2 kW up to 100 kW delivered by power supply working at frequency from 300 MHz to 30 GHz; and
- evaporating the undiluted trimethylborate and introducing the evaporation therefrom to the reactor; and
- introducing hydrogen to the reactor; wherein volume ratio between the evaporation and hydrogen is between 0.05 - 20%; and **characterized in that**
- the trimethylborate evaporation is the only precursor introducing the carbon and boron into the reactor, supporting the growth of the doped diamond structure; and introducing gaseous H₂O and/or O₂ into the reactor.

**2.** The method according to claim 1, wherein the step of introducing the gasses to the reactor is introducing the gasses into a linear antenna microwave chemical vapour deposition reactor.

**3.** The method according to anyone of the preceding claims, wherein the gases are introducing into the reactor separately via a flow meter.

**4.** The method according to claim 2 or 3 further comprising setting the linear antenna microwave chemical vapour deposition reactor substrate holder to direct current.

**5.** The method according to anyone of the claims 2 - 4 further comprising setting the linear antenna microwave chemical vapour deposition reactor substrate holder to alternating current.

**6.** The method according to anyone of the preceding claims, wherein the step of introducing trimethylborate into the reactor is from about 1 % to about 2 % by volume.

**7.** The method according to anyone of the preceding claims, wherein comprising the step of setting microwave power about 6 KW and the pressure about 30 Pa and setting the substrate temperature about 600 °C.

**8.** The method according to anyone of the claims 1 - 7 comprising the step of setting the microwave power of the reactor from about 200 W to about 6000 W.
